# EUROPÄISCHE PATENTANMELDUNG

(11) **EP 2 903 042 A1**
(43) Veröffentlichungstag der Anmeldung: **05.08.2015**
(21) Anmeldenummer: 14190569.5
(22) Anmeldetag: 28.10.2014
(51) Int. Cl.: H01L 35/32

(54) **Thermoelektrisches Modul und Verfahren zur Herstellung eines thermoelektrischen Moduls**

(30) Priorität: 12.11.2013 DE 102013223023
(71) Anmelder: ROBERT BOSCH GMBH, 70442 Stuttgart (DE)
(72) Erfinder: Pirk, Tjalf, 70195 Stuttgart (DE); Ehrenpfordt, Ricardo, 70825 Korntal-Muenchingen (DE); Ante, Frederik, 70197 Stuttgart (DE); Kenntner, Johannes, 70825 Korntal-Muenchingen (DE)

(57) **Zusammenfassung**

Die Erfindung betrifft ein thermoelektrisches Modul (100), das zumindest ein Trägerelement (115) aufweist, wobei das Trägerelement (115) zumindest einen Wärmeleitbereich (125) zur Wärmeleitung zwischen zwei gegenüberliegenden Seiten des Trägerelementes (115) aufweist, wobei der Wärmeleitbereich (125) eine höhere Wärmeleitfähigkeit als ein weiterer Bereich des Trägerelementes (115) aufweist. Ferner umfasst das thermoelektrische Modul (100) zumindest ein auf dem Wärmeleitbereich (125) des Trägerelementes befestigtes thermoelektrischen Element (110), wobei das thermoelektrische Element (110) mit dem Wärmeleitbereich (125) thermisch gekoppelt ist. Schließlich umfasst das thermoelektrische Modul (100) zumindest ein Abdeckelement (130), das auf einer dem Trägerelement (115) gegenüberliegenden Seite des thermoelektrischen Elementes(110) angeordnet ist und das thermoelektrische Element (110) zumindest teilweise überdeckt.

## Beschreibung

### Stand der Technik

Die vorliegende Erfindung bezieht sich auf ein thermoelektrisches Modul und auf ein Verfahren zur Herstellung eines thermoelektrischen Moduls sowie auf ein entsprechendes Computerprogrammprodukt.

Das "Internet der Dinge" (Internet of things, IoT) wird als eine der wichtigsten zukünftigen Entwicklung in der Informationstechnologie bezeichnet. Unter dem IoT versteht man, dass nicht nur Menschen Zugang zum Internet haben und über dieses vernetzt sind, sondern dass auch Geräte über das Internet miteinander vernetzt sind. Ein Bereich des "Internets der Dinge" zielt Richtung Produktions- und Hausautomatisierung, z. B. zur Temperaturmessung. Diese Sensoren sind bereits verfügbar (z. B. Temperatursensoren an der Heizung mit low-energy EnOcean-Funktechnolgie), jedoch liegen die Kosten mit sehr hoch.

Die Effizienz eines TEGs (TEG = thermoelektrischer Generator, hier auch als thermoelektrisches Element bezeichnet) hängt stark davon ab, wie schnell die aufgenommene Wärme wieder an die Umgebung abgegeben wird. Deshalb werden TEGs häufig mit einem sehr gut Wärme leitenden Kühlkörper (typischerweise aus Metall) ausgestattet, welcher die Wärme vom TEG abzieht und an die Umgebung abgibt. Die Oberfläche zwischen Kühlkörper und Umgebung sollte hierfür möglichst groß sein. Die Kühlkörper sind dabei nicht in das Gehäuse integriert, sondern zusätzlich angeklebt. Dies hat negative Auswirkungen auf das Design (keine vernünftige Integration in das Sensorsystem) und die Kosten (zusätzlicher Aufwand für die Fertigung und das Anbringen des Kühlkörpers). Als Alternative zu einem Kühlkörper kann ein Sensorelement beispielsweise mit Luft durchströmt werden, um die aufgenommene Wärme wieder abzugeben. Die Integration von Energiewandlern ist aktuell ein Trend auf dem Gebiet der Elektronik-Verpackungen. Speziell Solarzellen und thermoelektrische Wandler (TEG) werden für die Gewinnung elektrischer Energie z. B. zum Betreiben von Sensormodulen eingesetzt.

### Offenbarung der Erfindung

Vor diesem Hintergrund wird mit dem hier vorgestellten Ansatz ein thermoelektrisches Modul, ein Verfahren zur Herstellung eines thermoelektrischen Moduls sowie schließlich ein entsprechendes Computerprogrammprodukt gemäß den Hauptansprüchen vorgestellt. Vorteilhafte Ausgestaltungen ergeben sich aus den jeweiligen Unteransprüchen und der nachfolgenden Beschreibung.

Der hier vorgestellte Ansatz offenbart ein thermoelektrisches Modul mit folgenden Merkmalen:
- zumindest einem Trägerelement, wobei das Trägerelement zumindest einen Wärmeleitbereich zur Wärmeleitung zwischen zwei gegenüberliegenden Seiten des Trägerelementes aufweist, wobei der Wärmeleitbereich eine höhere Wärmeleitfähigkeit als ein weiterer Bereich des Trägerelementes aufweist;
- zumindest einem auf dem Wärmeleitbereich des Trägerelementes befestigten thermoelektrischen Element, wobei das thermoelektrische Element mit dem Wärmeleitbereich thermisch gekoppelt ist; und
- zumindest einem Abdeckelement, das auf einer dem Trägerelement gegenüberliegenden Seite des thermoelektrischen Elementes angeordnet ist und das thermoelektrische Element zumindest teilweise überdeckt.

Unter einem Trägerelement kann ein mechanisches Bauteil verstanden werden, welches als Stütze oder Halterungen für das thermoelektrische Element dienen kann. Unter einem Wärmeleitbereich kann ein Abschnitt des Trägerelements verstanden werden, in den Wärme zwischen zwei gegenüberliegenden Seiten des Trägerelements besser (das heißt mit einem geringeren Wärmewiderstand) geleitet werden kann, als in einem anderen Bereich des Trägerelements. Beispielsweise kann der Wärmeleitbereich eine Öffnung aufweisen, durch die ein Fluid wie beispielsweise ein Gas oder Luft von einer Seite des Trägerelements auf eine gegenüberliegende Seite des Trägerelements strömen kann. Auch kann der Wärmeleitbereich zumindest teilweise mit einem Wärmeleitmaterial als Wärmeleitelement gefüllt sein oder dieses aufweisen, wobei das Wärmeleitmaterial gegenüber einem anderen Material des Trägerelements eine deutlich höhere Wärmeleitfähigkeit aufweist als ein Hauptbestandteil des Trägerelementes. Unter einem thermoelektrischen Element kann ein elektronisches Bauteil verstanden werden, welches in der Lage ist, eine Differenz einer Temperatur an zwei unterschiedlichen Positionen oder Orten in eine elektrische Spannung bzw. eine elektrische Energie zu wandeln. Unter einem Abdeckelement kann ein mechanisches Bauelement verstanden werden, welches das thermoelektrische Element auf einer dem Trägerelement gegenüberliegenden Seite zumindest teilweise abdeckt und hierdurch das thermoelektrische Element (beispielsweise gegen Umwelteinflüsse) schützt.

Der hier vorgestellte Ansatz basiert auf der Erkenntnis, dass die Anordnung des thermoelektrischen Elements auf dem Trägerelement sowie das Vorsehen des Abdeckelements die Herstellung eines thermoelektrische Moduls ermöglicht, welches technisch sehr einfach (beispielsweise unter Verwendung einer Standardherstellungstechnologie für die Fertigung von elektronischen Komponenten) hergestellt werden kann. Das hergestellte thermoelektrische Modul bietet dabei eine besonders günstige (beispielsweise autarke) Energieversorgungsmöglichkeit insbesondere in Bereichen, in denen ein Temperaturgradient zwischen Temperaturen an unterschiedlichen Orten vorliegt. Der hier vorgestellte Ansatz bietet somit den Vorteil, ein kostengünstig und technisch einfach herzustellendes Energiebereitstellungsmodul zu schaffen, welches beispielsweise für die autarke Versorgung von Sensoren an schwer erreichbaren Orten verwendet werden kann.

Besonders günstig ist eine Ausführungsform der vorliegenden Erfindung, bei der das Trägerelement als Leiterplatte ausgestaltet ist, insbesondere wobei das Trägerelement zumindest eine Leiterbahn zur elektrischen Kontaktierung des thermoelektrischen Elementes aufweist. Eine derartige Ausführungsform der vorliegenden Erfindung bietet den Vorteil, dass eine Standardkomponente zur Fertigung des thermoelektrischen Moduls verwendet werden kann, die eine sehr kostengünstige Herstellung des thermoelektrischen Moduls zulässt.

Gemäß einer weiteren Ausführungsform der vorliegenden Erfindung kann das Trägermaterial im Wärmeleitbereich zumindest eine Öffnung und/oder oder zumindest ein Wärmeleitelement zur Wärmeleitung durch das Trägerelement aufweisen, wobei das Wärmeleitelement eine höhere Wärmeleitfähigkeit als ein Hauptbestandteilmaterial des Trägerelementes aufweist, insbesondere wobei das Wärmeleitelement zumindest teilweise ein Metall umfasst oder vollständig aus Metall besteht. Eine solche Ausführungsform der vorliegenden Erfindung bietet den Vorteil einer besonders effektiven Nutzung der Energiewandlungsfähigkeit des thermoelektrischen Elements, da in dem Wärmeleitbereich des Trägerelements ein Wärmewiderstand klein gehalten wird. Auf diese Weise kann ein hoher Wärmestrom im Wärmeleitbereich zum thermoelektrischen Element geführt werden.

Insbesondere dann, wenn das Trägerelement im Wärmeleitbereich zumindest eine Mehrzahl von Öffnungen aufweist, die (beispielsweise regelmäßig) in Reihen und/oder Spalten angeordnet sind, kann das thermoelektrische Modul besonders kostengünstig hergestellt werden, wobei die Stabilität des Trägerelements nicht unnötig reduziert wird.

Um einen besonders hohen Temperaturgradienten am thermoelektrischen Element sicherzustellen, kann gemäß einer weiteren Ausführungsform der vorliegenden Erfindung das Abdeckelement im das thermoelektrische Element überdeckenden Bereich zumindest eine Öffnung und/oder oder zumindest ein Abdeckleitelement zur Wärmeleitung durch das Abdeckelement aufweisen, wobei das Abdeckleitelement eine höhere Wärmeleitfähigkeit als ein Hauptbestandteilmaterial des Abdeckelements umfasst, insbesondere wobei das Abdeckleitelement zumindest teilweise ein Metall umfasst oder vollständig aus Metall besteht.

Denkbar ist ferner, dass gemäß einer anderen, technisch sehr einfach und somit kostengünstig herzustellenden Ausführungsform der vorliegenden Erfindung das Abdeckelement durch eine Vergussmasse und/oder eine Leiterplatte gebildet ist und/oder an einer dem Trägerelement gegenüberliegenden Seite in Kontakt mit dem thermoelektrischen Element steht.

Besonders sicher gegen Umwelteinflüsse kann das thermoelektrische Modul geschützt werden, wenn gemäß einer weiteren Ausführungsform der vorliegenden Erfindung ferner zumindest ein Zwischenelement vorgesehen ist, welches seitlich neben dem thermoelektrischen Element zwischen dem Abdeckelement dem Trägerelement angeordnet ist, insbesondere wobei das Zwischenelement zusammen mit dem Abdeckelement und dem Trägerelement ein Gehäuse ausbildet, welches das thermoelektrische Element zumindest teilweise einschließt.

Bei einer weiteren Ausführungsform der vorliegenden Erfindung, die insbesondere in Bezug auf eine Flexibilität bei einem Aufbau einer elektronischen Schaltung unter Verwendung des thermoelektrischen Moduls besonders günstig ist, kann das Zwischenelement zumindest eine Zwischenelementleiterbahn aufweisen, um einen elektrischen Leiter an und/oder im Trägerelement mit einem elektrischen Leiter an und/oder im Abdeckelement zu verbinden.

Gemäß einer weiteren Ausführungsform der vorliegenden Erfindung kann zwischen dem Zwischenelement und dem thermoelektrischen Element ein Hohlraum ausgebildet sein, insbesondere wobei der Hohlraum mit einem Fluid, insbesondere einem Gas oder Luft gefüllt ist. Eine solche Ausführungsform der vorliegenden Erfindung bietet den Vorteil einer guten Temperierungs- bzw. Kühlungsmöglichkeit des thermoelektrischen Elements, um einen besonders hohen Effizienzgrad des thermoelektrischen Moduls zu erreichen.

Besonders kompakt und kostengünstig lässt sich ein thermoelektrisches Modul dann herstellen, wenn gemäß einer Ausführungsform der vorliegenden Erfindung zumindest ein elektronisches Bauelement und/oder ein Sensorelement zum Erfassen einer physikalischen Größe, insbesondere wobei das Sensorelement mit dem thermoelektrischen Element elektrisch leitfähig verbunden ist, um mit einer vom thermoelektrischen Element bereitgestellten elektrischen Energie betrieben zu werden.

Günstig ist ferner eine Ausführungsform der vorliegenden Erfindung, bei der das zumindest eine Sensorelement auf einer dem thermoelektrischen Element zugewandten Seite des Abdeckelementes und/oder auf einer dem thermoelektrischen Element zugewandten Seite des Trägerelementes befestigt ist. Eine solche Ausführungsform der vorliegenden Erfindung bietet den Vorteil eines besonders guten Schutzes des Sensorelements gegenüber Umwelteinflüssen.

Vorteilhaft ist ferner auch eine Ausführungsform der vorliegenden Erfindung, bei der das zumindest ein Messfühler zur Erfassung einer physikalischen Größe und/oder einer anderen als der mit dem Sensorelement erfassbaren physikalischen Größe auf einer dem thermoelektrischen Element abgewandten Seite des Trägerelementes und/oder des Abdeckelementes angeordnet ist, insbesondere wobei der Messfühler mit dem thermoelektrischen Element elektrisch leitfähig verbunden ist, um mit von dem thermoelektrischen Element bereitgestellter Energie betrieben zu werden, insbesondere wobei der zumindest eine Messfühler von einem Gehäuse zumindest teilweise umschlossen ist. Eine solche Ausführungsform der vorliegenden Erfindung bietet den Vorteil, dass die physikalische Größe oder die andere physikalische Größe erfasst werden kann, wobei eine Messwerteverfälschung durch das thermoelektrische Element möglichst gut verhindert oder reduziert werden kann.

Günstig ist ferner eine Ausführungsform der vorliegenden Erfindung als Verfahren zur Herstellung eines thermoelektrischen Moduls, wobei das Verfahren die folgenden Schritte aufweist:
- Bereitstellen zumindest eines Trägerelements, wobei das Trägerelement zumindest einen Wärmeleitbereich zur Wärmeleitung zwischen zwei gegenüberliegenden Seiten des Trägerelementes aufweist, wobei der Wärmeleitbereich eine höhere Wärmeleitfähigkeit als ein weiterer Bereich des Trägerelementes aufweist, zumindest eines thermoelektrischen Elements und zumindest eines Abdeckelements; und
- Anordnen des Trägerelementes, des thermoelektrischen Elementes und des Abdeckelementes derart, dass das thermoelektrische Element auf dem Wärmeleitbereich des Trägerelementes befestigt und mit dem Wärmeleitbereich thermisch gekoppelt wird und dass das Abdeckelement auf einer dem Trägerelement gegenüberliegenden Seite des thermoelektrischen Elementes angeordnet wird und das thermoelektrische Element zumindest teilweise überdeckt.

Der hier vorgestellte Ansatz schafft ferner eine Vorrichtung, die ausgebildet ist, um die Schritte einer Variante eines hier vorgestellten Verfahrens in entsprechenden Einrichtungen durchzuführen bzw. umzusetzen. Auch durch diese Ausführungsvariante der Erfindung in Form einer Vorrichtung kann die der Erfindung zugrunde liegende Aufgabe schnell und effizient gelöst werden.

Unter einer Vorrichtung kann vorliegend ein elektrisches Gerät verstanden werden, das Sensorsignale verarbeitet und in Abhängigkeit davon Steuer- und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert sein kann und zur Durchführung des Verfahrens nach einer der vorstehend beschriebenen Ausführungsformen verwendet wird, wenn das Programmprodukt auf einem Computer oder einer Vorrichtung ausgeführt wird. Somit schafft der hier vorgestellte Ansatz ein Computer-Programmprodukt mit Programmcode zur Durchführung und/oder Ansteuerung der Schritte des Verfahrens gemäß einer hier vorgestellten Variante, wenn das Programmprodukt auf einer Vorrichtung ausgeführt wird.

Der hier vorgestellte Ansatz wird nachstehend anhand der beigefügten Zeichnungen beispielhaft näher erläutert. Es zeigen:
- Fig. 1: eine Schnittdarstellung eines Ausführungsbeispiels der vorliegenden Erfindung als thermoelektrisches Modul;
- Fig. 2: eine Schnittdarstellung eines weiteren Ausführungsbeispiels der vorliegenden Erfindung als thermoelektrisches Modul;
- Fig. 3: eine Schnittdarstellung eines weiteren Ausführungsbeispiels der vorliegenden Erfindung als thermoelektrisches Modul;
- Fig. 4: eine Schnittdarstellung eines weiteren Ausführungsbeispiels der vorliegenden Erfindung als thermoelektrisches Modul;
- Fig. 5: eine Schnittdarstellung eines weiteren Ausführungsbeispiels der vorliegenden Erfindung als thermoelektrisches Modul;
- Fig. 6A-6C: Aufsichtsdarstellungen auf unterschiedliche Ausführungsbeispiele eines thermoelektrischen Moduls in Anlehnung an die in Fig. 1 bis Fig. 5 gezeigten Ausführungsbeispiele der vorliegenden Erfindung als thermoelektrisches Modul;
- Fig. 7: eine Schnittdarstellung eines weiteren Ausführungsbeispiels der vorliegenden Erfindung als thermoelektrisches Modul;
- Fig. 8: eine Schnittdarstellung eines weiteren Ausführungsbeispiels der vorliegenden Erfindung als thermoelektrisches Modul;
- Fig. 9: eine Schnittdarstellung eines weiteren Ausführungsbeispiels der vorliegenden Erfindung als thermoelektrisches Modul; und
- Fig. 10: ein Ablaufdiagramm eines Ausführungsbeispiels der vorliegenden Erfindung als Verfahren zur Herstellung eines thermoelektrischen Moduls.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

Ein wichtiger Aspekt des hier vorgestellten Ansatzes ist die Schaffung der Möglichkeit einer einfachen, robusten und kleinbauenden Integration von TEGs als Energiewandler beispielsweise in elektronische, autonome Sensorsysteme. Ein hohes Potenzial, vor allem hinsichtlich geringer Kosten für die Aufbau- und Verbindungstechnik stellen Aufbaukonzepte dar, welche weitestgehend auf Standard-Prozessen beruhen, wie sie unter anderem für die Gehäuse von Elektroniken (IC = integrated circuit = integrierte Schaltung), weltweit Verwendung finden.

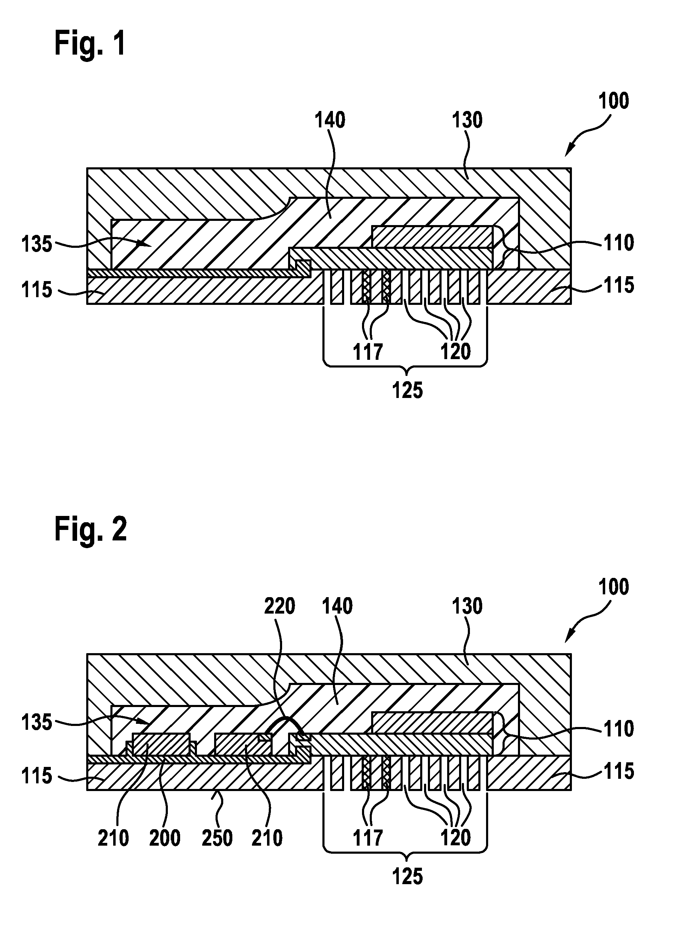

In Fig. 1 ist in Querschnittsdarstellung ein Ausführungsbeispiel eines Systems als thermoelektrisches Modul 100 wiedergegeben, welches einen thermoelektrischen Generator (TEG), der auch als thermoelektrisches Element 110 bezeichnet werden kann, auf einer Leiterplatte als Trägerelement 115 beinhaltet. Das Trägerelement 115 (hier als Leiterplatte oder printed circuit board (PCB) ausgestaltet) beinhaltet die Kontaktierung des TEG 110 und Vias (Wärmeleitelemente 117) oder Öffnungen 120 in einem Wärmeleitbereich 125 des Trägerelements 115, um eine thermische Anbindung an den TEG 110 auf einer ersten Seite T1 oder einer zweiten Seite T2 des thermoelektrischen Elementes 110 herzustellen. Die anderen Seiten des TEGs 110 sind von Mold- oder Vergussmasse als Abdeckelement 130 umgeben. Um eine Kavität (d. h. einen Hohlraum 135) mit definierten geometrischen Abmessungen zwischen der Moldmasse 130 und dem TEG 110 herzustellen, können thermisch zersetzbare Polymere 140 (Thermo Disposable Polymers (TDP)) auf das thermoelektrische Element 110 und die Leiterplatte 115 aufgebracht werden, bevor diese Polymere 140 mit der Vergussmasse 130 übergossen werden. Diese Polymere 140, die dann nach einer Abkühlung und/oder Aushärtung das Abdeckelement 130 bilden, überdecken dann das thermoelektrische Element 110 zumindest teilweise (im Ausführungsbeispiel gemäß der Darstellung aus Fig. 1 vollständig). Die Polymere 140 werden somit auf dem PCB 115 über dem TEG 110 aufgetragen und anschließend mit der Moldmasse 130 übergossen. Durch einen anschließenden Temperschritt werden die TDPs 140 zersetzt und ein Hohlraum 135 entsteht. Dieser Hohlraum 135 kann genutzt werden, um den nötigen Temperaturgradienten am TEG 110 zu generieren. Hierfür kann beispielsweise Kühlflüssigkeit in den Hohlraum 135 geleitet werden, wie es in der Fig. 1 jedoch nicht näher dargestellt ist. Auch ein Umspülen des TEG 110 mit Gasen ist dabei denkbar. Je nach Anwendungsfall kann auch die dem Hohlraum 135 zugewandte Seite T2 des TEG 110 erwärmt und die dem PCB 115 zugewandte Seite T1 des TEG 110 gekühlt werden.

In der Fig. 1 ist somit ein mögliches Aufbaukonzept gemäß einem Ausführungsbeispiel der Erfindung in der Schnittdarstellung wiedergegeben. Der thermoelektrische Generator 110 (TEG) ist auf einem PCB als Trägerelement 115 aufgebracht. Die anderen Seiten des TEG 110 werden durch Moldmasse 130 gehaust. Mittels thermisch zersetzbaren Polymeren 140 entsteht ein Hohlraum 135 zwischen PCB 115 und Moldmasse 130. Dieser Hohlraum 135 kann mittels Flüssigkeiten oder Gasen zur Kühlung oder Erwärmung genutzt werden.

Fig. 2 zeigt ein Aufbaukonzept eines thermoelektrischen Moduls gemäß einem Ausführungsbeispiel der Erfindung in der Schnittdarstellung. Der thermoelektrische Generator 110 (TEG) ist derart in die Vergussmasse als Abdeckelement 130 und die Leiterplatte (PCB) als Trägerelement 115 integriert, dass er auf einer Seite von einem PCB 115 gehaust ist. Die thermische Anbindung des TEGs 110 erfolgt durch in dem PCB 115 vorgesehene Wärmeleitelementes 117 (Vias) oder Öffnungen 120. Die elektrische Kontaktierung des thermoelektrischen Elements 110 (TEG) erfolgt durch (eine oder mehrere) Leiterbahnen 200 auf und/oder in dem PCB 115. Sensoren 210 zur Erfassung einer oder mehrerer physikalischen/physikalischer Größe(n) können über Standard-IC-Prozesse, wie FC - Bonden, Löten oder Drahtbonden auf das PCB (Trägerelement 115) bestückt und zur Versorgung mit Energie für den Betrieb der Sensoren 200 mittels eines Anschlussleiters 220 und/oder über die Leiterbahnen 200 mit dem thermoelektrischen Element 110 elektrisch leitfähig verbunden werden. Eine Hausung des TEG 110 in die verbleibenden Richtungen erfolgt durch Moldmasse 130. Ein definierter geometrischer Hohlraum 135 zwischen Moldmasse 130 und PCB 115 wird durch thermisch zersetzbare Polymere 140 (TDP) hergestellt, wie dies bereits mit Bezug zur Fig. 1 näher beschrieben wurde. Dieser Hohlraum 135 kann gekühlt oder erwärmt werden, um einen möglichst hohen Temperaturgradienten am TEG 110 herzustellen.

In Fig. 2 ist somit ein typisches Ausführungsbeispiel eines Sensorsystems als thermoelektrisches Modul 100 gezeigt. Es beinhaltet mindestens einen TEG 110 und kann weitere Sensoren 200 oder IC-Komponenten (Temperatursensor, ASICs, Funkmodule) beinhalten, welche beispielsweise durch Kleben auf die Leiterplatte 115 aufgebracht sind. Die Leiterplatte 115 kann mehrere Metallisierungsebenen (die unterschiedliche, voneinander elektrisch isolierte Leiterbahnen 200 enthalten) umfassen. Die Metallisierungsebene des PCB 115 beinhaltet die Umverdrahtung der Sensoren 200 und des TEG 110 untereinander. Auf der Unterseite 250 des unteren PCB 115 (d. h. der dem thermoelektrischen Element 110 abgewandten Seite des Trägerelementes 115) können sich auch eine oder mehrere metallische Flächen befinden, um das Sensorsystem elektrisch zu kontaktieren oder um es auf eine weitere Leiterplatte aufzulöten. Diese metallischen Flächen sind in der Fig. 2 jedoch nicht näher dargestellt. Die PCB 115 weisen beispielsweise thermische Vias in Form von Metallisierungen 117 (als Wärmeleitelemente) oder gefrästen oder gelaserten Öffnungen 120 auf, sodass ein thermischer Zugang mit einem geringen Wärmewiderstand zu einer der Seiten (T1 oder T2) des TEGs 110 eröffnet wird. Auf der dem Trägerelement 115 gegenüberliegenden Seite des thermoelektrischen Elementes 110 wird das System (bzw. das thermoelektrische Modul) 100 durch Moldmasse 130 gekapselt. Um eine Kavität 135 mit definierten geometrischen Abmessungen zwischen der Moldmasse 130 und dem TEG 110 beziehungsweise den Sensoren 200 herzustellen, können thermisch zersetzbare Polymere 140 (Thermo Disposable Polymers (TDP)) genutzt werden. Diese werden auf dem PCB 115 über den Sensoren 210 und dem TEG 110 aufgetragen und anschließend mit der Moldmasse 130 übergossen. Durch einen anschließenden Temperschritt werden die TDPs 140 zersetzt und ein Hohlraum 135 entsteht.

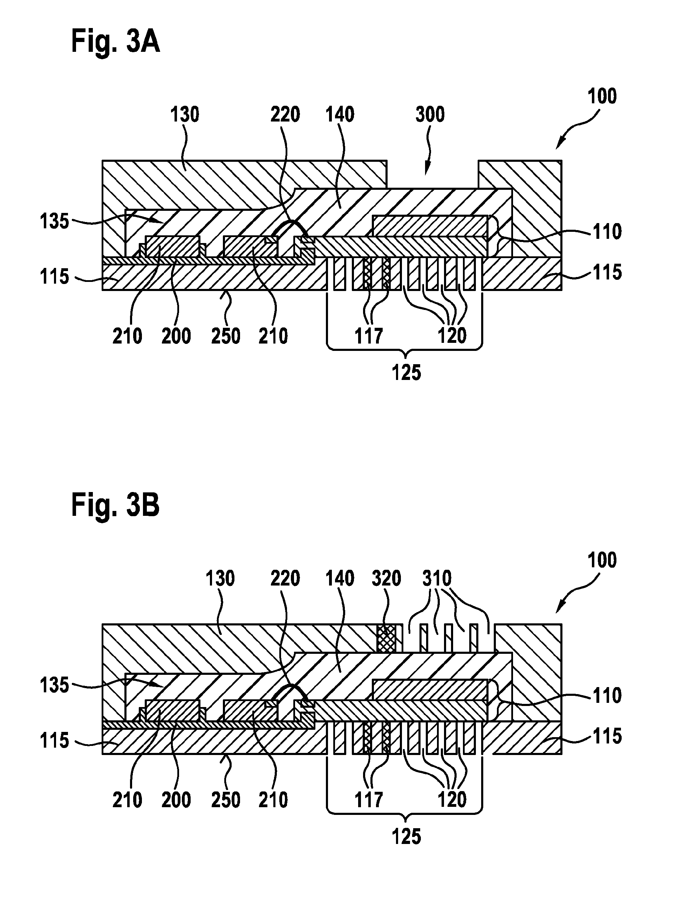

Fig. 3A und 3B zeigen Schnittdarstellungen von weiteren Ausführungsbeispielen eines thermoelektrischen Moduls 100 der vorliegenden Erfindung. Dabei sind in den Figuren 3A und 3B im Wesentlichen thermoelektrische Module (bzw. Sensorsysteme) gemäß dem in der Fig. 2 dargestellten und erläuterten Prinzip wiedergegeben, jedoch ist im Unterschied zu dem in Fig. 2 dargestellten Ausführungsbeispiel das Abdeckelement 130 im Bereich des thermoelektrischen Elementes 110 anders ausgestaltet. Durch die Verwendung eines geeigneten Formwerkzeugs kann während des Moldprozesses zur Herstellung des Abdeckelementes 130 aus der Vergussmasse, welches direkt auf dem TDP 140 aufsetzt wird, ein thermischer Zugang zur ersten Seite T1 (kann auch T2 sein) des TEG 110 hergestellt werden. Die geometrische Ausführung des thermischen Zugangs ist dabei prinzipiell beliebig herstellbar. In dem in der Fig. 3A dargestellten Ausführungsbeispiel ist durch dieses Formwerkzeug beispielsweise ein großflächiger quadratischer Zugang bzw. eine Öffnung 300 ausgebildet, durch welche ein Fluid wie beispielsweise ein Gas wie Luft oder eine Flüssigkeit die zweite Seite T2 (kann auch T1 sein) des thermoelektrischen Elementes 130 erreichen kann. In dem in der Fig. 3B dargestellten Ausführungsbeispiel sind durch dieses Formwerkzeug beispielsweise einzelne kleinere Öffnungen 310 (Moldvias) ausgebildet, durch welche ein ebenfalls Fluid wie beispielsweise ein Gas wie Luft oder eine Flüssigkeit die zweite Seite T2 bzw. die erste Seite T1 des thermoelektrischen Elementes 130 erreichen kann, wobei jedoch die Stabilität des Abdeckelementes 130 durch das Vermeiden einer großflächigen Öffnung (wie sie in der Fig. 3A dargestellt ist) erhöht werden kann. Fig. 3 zeigt somit Ausführungsbeispiele eines thermoelektrischen Elementes, bei dem mittels eines Formwerkzeugs ein Zugang zur ersten Seite T1 und/oder der zweiten Seite T2 des TEG 110 ermöglicht wird.

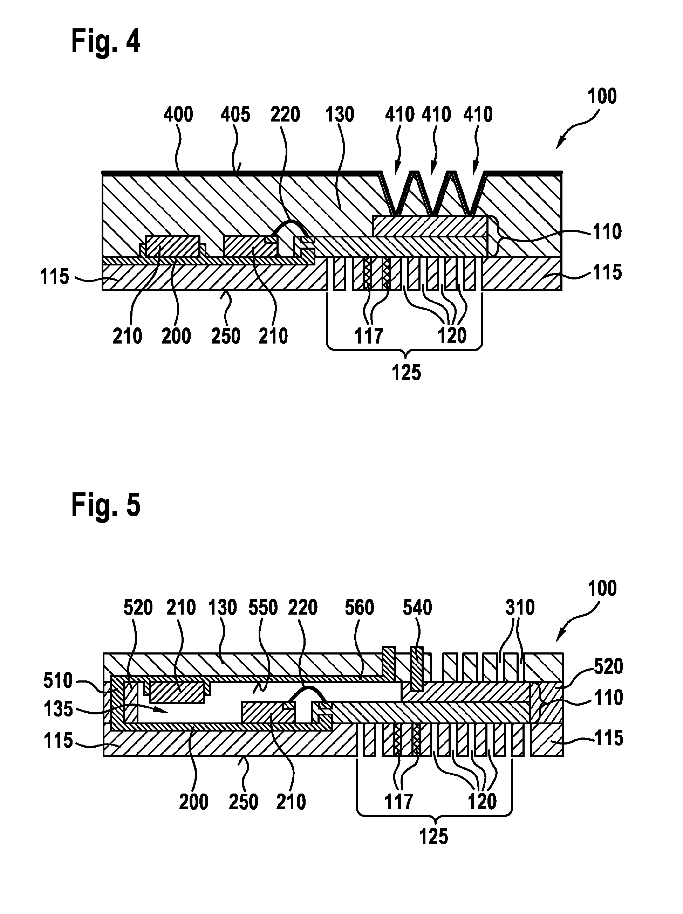

Fig. 4 zeigt eine Schnittdarstellung eines thermoelektrischen Moduls 100 gemäß einem weiteren Ausführungsbeispiel mit einem mittels Formwerkzeug hergestellten Zugang zur ersten Seite T1 des TEG 110. Ein Hohlraum 135, beispielsweise durch das Vorsehen und nachfolgende Zersetzen des Polymers 140, wie es mit Bezug auf die Ausführungsbeispiele aus den Figuren 2 und 3 beschrieben ist, ist zur Herstellung des in Fig. 4 dargestellten thermoelektrischen Moduls 100 dabei nicht zwingend erforderlich. Eine optimierte thermische Anbindung erfolgt in diesem Ausführungsbeispiel beispielsweise durch eine Metallisierungsschicht 400 der Oberfläche 405 des (beispielsweise durch Vergussmasse hergestellten) Abdeckelementes 130 beispielsweise durch Sputtern oder Aufdampfen. Dabei kann durch ein Formwerkzeug eine Strukturierung der Oberfläche des Abdeckelementes 130 erfolgen, beispielsweise in der Form von Ausnehmungen 410, auf deren Oberfläche die Metallschicht 400 ebenfalls abgeschieden wird. In einem günstigen Ausführungsbeispiel kann die Metallschicht 400 dann beispielsweise die erste Seite T1 oder T2 des thermoelektrischen Elementes 110 kontaktieren. Durch das Formwerkzeug wird somit der thermische Zugang durch die Moldmasse hergestellt. Eine optimierte thermische Anbindung kann dabei durch eine Metallisierung der Moldoberfläche erreicht werden.

Das hier vorgestellte autonome Sensorsystem 100 kann prinzipiell durch Standard-Leiterplattentechnologien hergestellt werden. In einem ersten Schritt kann das PCB mit TEG 110 und Komponenten 210 bestückt werden. Für die Herstellung von Hohlräumen 135 wird das TDP 140 aufgebracht. Dies kann beispielsweise durch Aufkleben von Platten oder Spincoaten geschehen. Nach einer Strukturierung des TDP 140 wird das System 100 übermoldet, um es nach außen zu verkapseln. Die Moldmasse 130 kann durch geeignete Formwerkzeuge selbst strukturiert werden, um die thermischen Eigenschaften zu optimieren.

Ferner ist auch ein Ausführungsbeispiel eines thermoelektrischen Moduls 100 denkbar, wie es in der Schnittdarstellung aus Fig. 5 abgebildet ist. Im Unterschied zu den in den Figuren 1 bis 4 dargestellten Ausführungsbeispielen ist in der Fig. 5 ein Aufbaukonzept des Ausführungsbeispiels dargestellt, bei dem der thermoelektrische Generator 110 (TEG) derart integriert ist, dass er mindestens von der Ober- und Unterseite von Leiterplatten (PCBs) umgeben ist. Dabei bildet die untere Leiterplatte das Trägerelement 115 und die obere Leiterplatte das Abdeckelement 130. Die thermische Anbindung erfolgt auf beiden Seiten des TEGs 110 durch in den PCBs 115 bzw. 130 vorgesehene Vias 117 oder Öffnungen 120 bzw. 310. Die elektrische Kontaktierung des thermoelektrischen Elementes 110 erfolgt durch Leiterbahnen 200 bzw. 500 auf den PCBs des Trägerelementes 115 bzw. des Abdeckelementes 130. Das obere 130 und das untere PCB 115 können durch Durchkontakte 510 in einem das System bzw. thermoelektrische Modul 100 umgebenden Rahmen 520 miteinander verbunden werden. Sensoren 210 können über Standard-IC-Prozesse, wie FC-Bonden, Löten oder Drahtbonden sowohl auf dem oberen 130 als auch auf dem unteren PCB 115 in den Hohlraum 135 bestückt werden. Auch können in den Öffnungen 310 der oberen Leiterplatte 130 Abdeckleitelemente 540 eingebracht sein, um eine elektrische Kontaktierung des thermoelektrischen Generators 110 durch das Abdeckelement 130 und/oder eine Wärmeleitung durch das Abdeckelement130 im Bereich des thermoelektrischen Elementes 110 zu verbessern. Hierzu können die Abdeckleitelemente 540 ein besonders gut elektrisch leitendes Material und/oder ein besonders gut thermisch leitendes Material verwenden. Beispielsweise bietet sich Kupfer als Material für das oder die Abdeckelemente 540 an.

In der Fig. 5 ist somit ein weiteres beispielhaftes Sensorsystem bzw. thermoelektrisches Modul 100 gezeigt. Es beinhaltet mindestens einen TEG 110 und kann weitere Sensoren 210 oder IC-Komponenten (Temperatursensor, ASICs, Funkmodule) beinhalten, welche beispielsweise durch Kleben auf die Leiterplatte aufgebracht sind. Die Leiterplatte 115 kann mehrere Metallisierungsebenen umfassen. Die oberste Metallisierungsebenen (bzw. Leiterbahnen 200) des unteren PCB 115 bzw. die unterste Metallisierungsebene des oberen PCB 115 beinhaltet beispielsweise die Umverdrahtung der Sensoren 210 und des TEG 110 untereinander. Auf der Unterseite des unteren PCB 115 können sich auch metallische Flächen befinden, um das in der Fig. 5 dargestellte Sensorsystem 100 als thermoelektrisches Modul 100 elektrisch zu kontaktieren oder um es auf eine weitere Leiterplatte aufzulöten. Zur elektrischen Verbindung der einzelnen Signalebenen können elektrische Vias in der Leiterplatte 115 prozessiert sein. Dabei kann sich das Sensorsystem 100 auch an einer Oberseite des PCB 115 befinden. Die elektrische Verbindung des oberen 130 und unteren PCBs 115 kann durch Durchkontakte 510 in einem das System 100 umlaufenden Rahmen 520 hergestellt werden. Die PCBs 115 bzw. 130 weisen beispielsweise thermische Vias 125 bzw. 117 oder 310 bzw. 320 auf, sodass ein thermischer Zugang zu der ersten Seite T1 und zweiten Seite T2 des TEGs 110 eröffnet ist, die übrigen Sensoren 210 aber vor Umwelteinflüssen geschützt sind. In der oberen Leiterplatte130, die als Abdeckelement verwendet wird, ist an einer Unterseite 550 ebenfalls eine Leiterbahn 560 zur Kontaktierung von Komponenten wie beispielsweise Sensoren 210 oder dergleichen vorgesehen, die an dem Abdeckelement 130 befestigt und elektrisch kontaktiert sind.

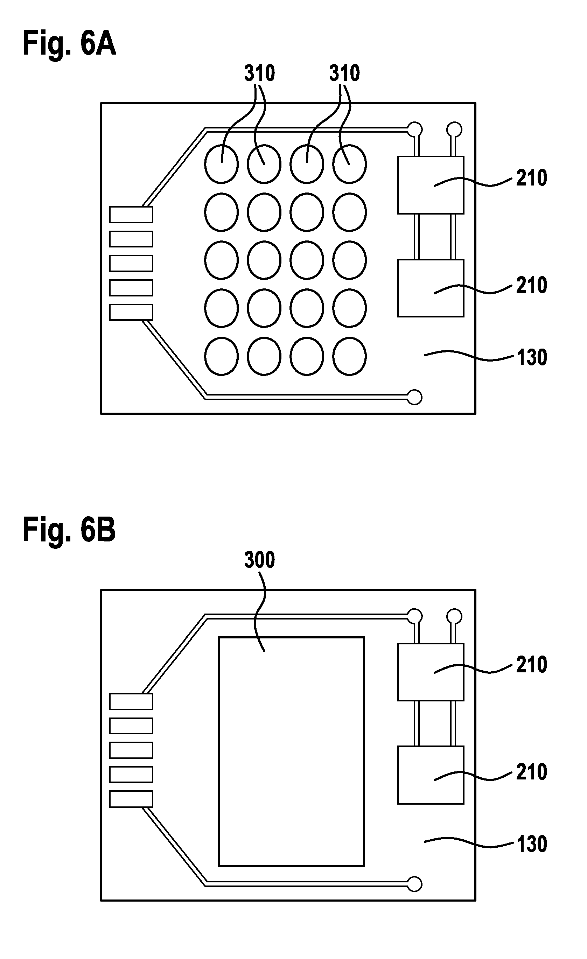

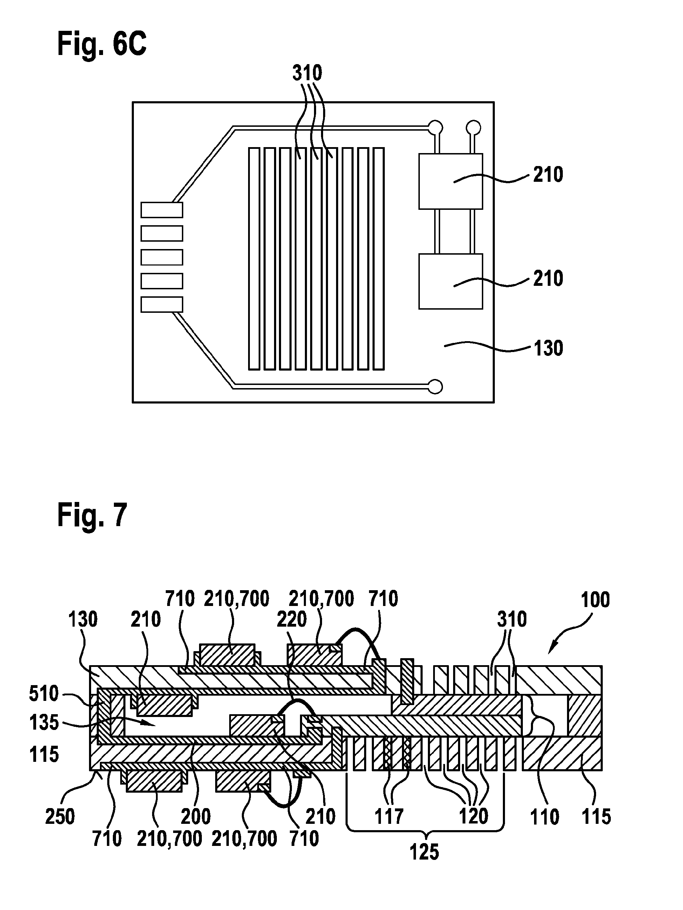

Fig. 6A bis 6C zeigt Aufsichtsdarstellungen von verschiedenen Ausführungsbeispielen einer Öffnung im Abdeckelement 130 eines thermoelektrischen Moduls 100 in Anlehnung an das Ausführungsbeispiel gemäß der Fig. 5. Der thermoelektrische Generator 110 ist vom oberen PCB 130 umgeben. An Kontaktflächen T1 und T2 des TEG 110 sind PCBs 130 bzw. 115 mit metallisierten Kontaktflächen angeordnet, welche unter anderem der Kontaktierung des Systems 100 durch Löten dienen können. Darüber hinaus stellen Vias bzw. Öffnungen 310 in verschiedener Ausführung den thermischen Zugang zum TEG 110 sicher. Hier sind exemplarisch runde Vias 310 (wie in der Fig. 6A dargestellt), eine ganzflächig ausgefräste Öffnung 310 in der oberen Leiterplatte 130 (wie in der Fig. 6B dargestellt) oder lamellenförmig ausgefräste Kontaktöffnungen 310 (wie in der Fig. 6C dargestellt) wiedergegeben. Prinzipiell sind jedoch beliebige Formen der Kontaktöffnung 310 denkbar.

Die Ausführung der thermischen Kontakte ist nicht nur auf Bohrungen bzw. Vias 310 beschränkt. Die geometrische Ausführung der Kontakte ist dabei, wie in Fig. 6 dargestellt prinzipiell beliebig gestaltbar.

In der Fig. 7 ist ein Aufbaukonzept nach einem weiteren Ausführungsbeispiel der Erfindung in der Schnittdarstellung wiedergegeben. Im Gegensatz zu dem in Fig. 5 dargestellten Aufbau können die Sensoren 210 neben dem Hohlraum 135 auch auf den äußeren Seiten der beiden PCBs 115 bzw. 130 als Messfühler 700 bestückt und mit an den entsprechenden Seiten der Leiterplatten 115 bzw. 130 angeordneten Leiterbahnen 710 elektrisch kontaktiert werden. Insbesondere für klein bauende autonome Sensorsysteme 100 ist somit auch eine Bestückung der nach außen zeigenden Seiten der PCBs 115 bzw. 130 mit Sensorkomponenten 210 möglich. Somit können die Sensordichte und die Funktionalität des Systems 100 nochmals deutlich erhöht werden.

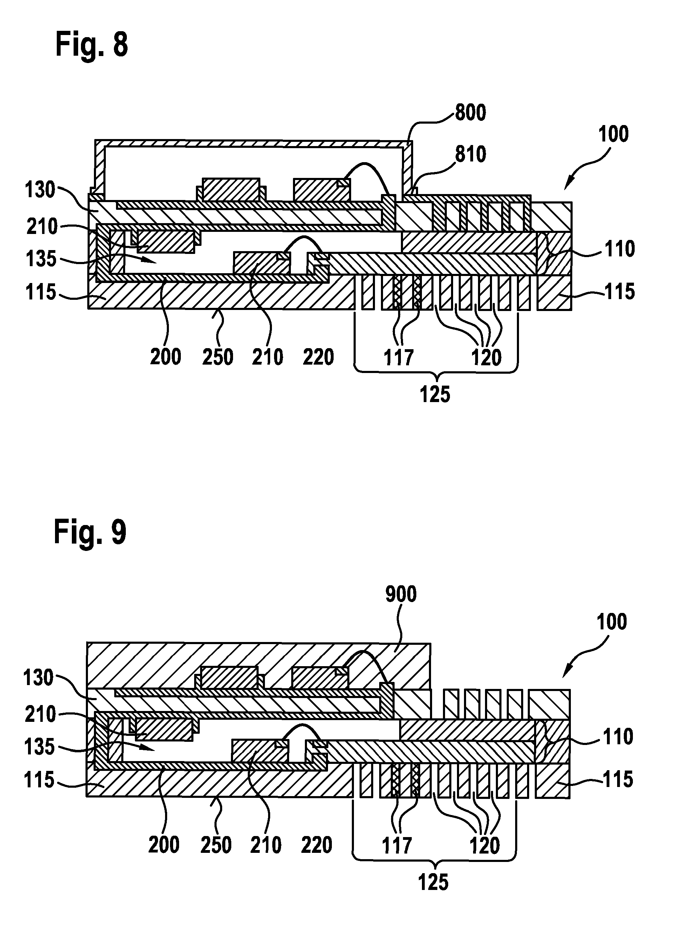

Fig. 8 zeigt eine Schnittdarstellung eines weiteren Ausführungsbeispiels der vorliegenden Erfindung als thermoelektrisches Modul 100. Bei einer Bestückung der nach außen zeigenden Seiten der Leiterplatten 115 bzw. 130 wird teilweise jedoch auch eine Kapselung der empfindlichen Komponenten 210 benötigt. Dies kann beispielsweise, wie in Fig. 8 dargestellt, durch die Montage eines Deckels 800 geschehen. Bei der Bestückung der äußeren Seiten des PCBs 115 bzw. 130 (was in der Fig. 8 nur am Beispiel einer Bestückung der äußeren Seite der oberen Leiterplatte 130 gezeigt ist) mit Sensoren 210 oder anderen IC-Komponenten, können diese somit durch einen Deckel 800 geschützt werden. Weiterhin denkbar ist es, unter Nutzung eines Deckels 800 aus Metall die große Oberfläche des Deckels 800 zur Wärmeabführung des TEGs 110 zu nutzen. Der Deckel 800 kann hierfür beispielsweise über metallische Kontakte 810 auf der Leiterplatte 130 mit den thermischen Vias 320 verbunden werden, wie es in der Fig. 8 offenbart ist.

Fig. 9 zeigt eine Schnittdarstellung eines weiteren Ausführungsbeispiels der vorliegenden Erfindung als thermoelektrisches Modul 100. Bei einer Bestückung der äußeren Seiten des PCB 130 bzw. 115 (was in der Fig. 9 jedoch nicht dargestellt ist) mit Sensoren 210 oder anderen IC Komponenten, können diese auch durch Moldmasse 900 geschützt werden. Hierfür wird jedoch ein Moldwerkzeug benötigt, welches die thermischen Vias 320 freistellt. Eine kostengünstige Alternative die nach außen zeigenden Komponenten 210 zu schützen stellt somit beispielsweise das Moldverfahren dar. Das Material der Verkapselung besteht beispielsweise aus einem Duroplastmaterial, welches einen hohen thermischen Widerstand aufweist. Daher ist es vorteilhaft, die thermischen Kontaktflächen T1 und T2 des TEG 110 freizustellen, was beispielsweise durch geeignete Moldwerkzeuge machbar ist.

Der hier vorgestellte Ansatz schafft somit ein Aufbau- und Verpackungskonzept für thermoelektrische Generatoren 110 (TEG) in elektronischen Systemen 100 (thermoelektrischen Modulen) und das Verfahren zur Herstellung des Systems. Dabei kann ein solches thermoelektrisches Modul 100 mindestens einen Umverdrahtungsbereich auf jeder Leiterplatte 115, welcher Kontaktflächen und/oder Leiterbahnen 200 zur elektrischen und mechanischen Kontaktierung des thermoelektrischen Elementes 110 und/oder weiteren Komponenten wie den Sensoren 210 enthält. Auch kann ein thermoelektrisches Modul 100 weiterhin mindestens einen thermoelektrischen Generator 110 aufweisen und weiterhin mindestens ein elektronisches Bauelement wie beispielsweise einen Sensor 210. Dabei kann der thermoelektrische Generator 110 an beiden thermischen Seiten T1 und T2 gehaust sein und/oder die Ober- und Unterseite (T1 und T2) des TEG 110 mit der Umgebung thermisch durch ein oberes und/oder unteres PCB als Trägerelement 115 oder die Moldmasse als Abdeckelelement 130 hergestellt werden. Ferner kann sich der Rahmen 115 um den TEG und das Sensorsystem erstrecken und dieses umschließen. Insbesondere kann in dem hier vorgestellten Ansatz zur Herstellung eines thermoelektrischen Moduls 100 vorteilhafterweise eine Leiterplattentechnologie verwendet werden, bei der die elektrischen Kontaktflächen der Leiterplatten über Standard-AVT-Kontaktierungstechnologien wie das Drahtbonden mit dem TEG oder den elektronischen Bauelementen kontaktiert werden. Auch kann der der Rahmen elektrische Durchkontakte enthalten, welche die Kontaktflächen an der Oberseite mit den Kontaktflächen an der Unterseite des Rahmens elektrisch leitend verbinden. Der hier vorgestellte Ansatz eines thermoelektrischen Moduls bietet den Vorteil des Einbringens des thermoelektrischen Generators über Standard-AVT-Technologien (Bestücken). Ferner können gemäß unterschiedlichen Ausführungsbeispielen der Erfindung auch elektrische Kontakte zum Umverdrahtungsbereich über Standard-AVT-Technologien (u.a. Drahtbonden, Löten, ... ) erstellt werden. Auch können Durchkontakte zu den elektrischen Kontaktflächen auf der Unterseite des Systems über Standard-Technologien der Leiterplattenfertigung (Durchkontakte) hergestellt werden. Zusätzlich bietet ein thermoelektrisches Modul gemäß dem hier vorgestellten Ansatz eine hohe Zuverlässigkeit durch bekannte Materialgrenzflächen und eine hohe Designfreiheit durch die Möglichkeit einer Umverdrahtung in der/den Leiterplatte(n) und über bekannte und kostengünstige Leiterplattenprozesse, Kantenkontakte oder Lands. Auch kann vorteilhaft eine Standard-AVT-Prozessfolge (beispielsweise ein Bestücken, Drahtbonden, Molden, etc.) verwendet werden wodurch sich durch die Verwendung von Standardprozessen geringe Herstellungskosten für ein solches thermoelektrisches Moduls realisieren lassen. Kostensenkend ist auch die Verwendung von Standardmaterialien (PCB-Duroplast, Kupfer, Moldmasse, Silizium) wobei ein Zusammenwirken der Materialien über Temperatur und Alterung vorteilhafterweise bekannt ist.

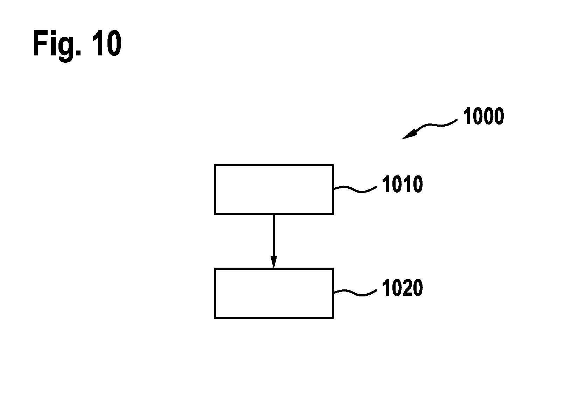

Fig. 10 zeigt ein Ablaufdiagramm eines Ausführungsbeispiels der vorliegenden Erfindung als Verfahren 1000 zur Herstellung eines thermoelektrischen Moduls. Das Verfahren 1000 umfasst einen Schritt des Bereitstellens 1010 zumindest eines Trägerelements, wobei das Trägerelement zumindest einen Wärmeleitbereich zur Wärmeleitung zwischen zwei gegenüberliegenden Seiten des Trägerelementes aufweist, wobei der Wärmeleitbereich eine höhere Wärmeleitfähigkeit als ein weiterer Bereich des Trägerelementes aufweist, eines thermoelektrischen Elements, und zumindest eines Abdeckelements. Ferner umfasst das Verfahren 1000 einen Schritt 1020 des Anordnens des Trägerelementes, des thermoelektrischen Elementes und des Abdeckelementes derart, dass das thermoelektrische Element auf dem Wärmeleitbereich des Trägerelementes befestigt und mit dem Wärmeleitbereich thermisch gekoppelt wird und dass das Abdeckelement auf einer dem Trägerelement gegenüberliegenden Seite des thermoelektrischen Elementes angeordnet wird und das thermoelektrische Element zumindest teilweise überdeckt.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können die hier vorgestellten Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Thermoelektrisches Modul (100) mit folgenden Merkmalen:
- zumindest einem Trägerelement (115), wobei das Trägerelement (115) zumindest einen Wärmeleitbereich (125) zur Wärmeleitung zwischen zwei gegenüberliegenden Seiten des Trägerelementes (115) aufweist, wobei der Wärmeleitbereich (125) eine höhere Wärmeleitfähigkeit als ein weiterer Bereich des Trägerelementes (115) aufweist;
- zumindest einem auf dem Wärmeleitbereich (125) des Trägerelementes befestigten thermoelektrischen Element (110), wobei das thermoelektrische Element (110) mit dem Wärmeleitbereich (125) thermisch gekoppelt ist; und
- zumindest einem Abdeckelement (130), das auf einer dem Trägerelement (115) gegenüberliegenden Seite des thermoelektrischen Elementes(110) angeordnet ist und das thermoelektrische Element (110) zumindest teilweise überdeckt.

2. Thermoelektrisches Modul (100) gemäß Anspruch 1, **dadurch gekennzeichnet, dass** das Trägerelement (115) als Leiterplatte ausgestaltet ist, insbesondere wobei das Trägerelement (115) zumindest eine Leiterbahn (200) zur elektrischen Kontaktierung des thermoelektrischen Elementes (110) aufweist.

3. Thermoelektrisches Modul (100) gemäß einem der vorangegangenen Ansprüche, **dadurch gekennzeichnet, dass** das Trägermaterial im Wärmeleitbereich (125) zumindest eine Öffnung (120) und/oder oder zumindest ein Wärmeleitelement (117) zur Wärmeleitung durch das Trägerelement (115) aufweist, wobei das Wärmeleitelement (117) eine höhere Wärmeleitfähigkeit als ein Hauptbestandteilmaterial des Trägerelementes (115) aufweist, insbesondere wobei das Wärmeleitelement (117) zumindest teilweise ein Metall umfasst oder vollständig aus Metall besteht.

4. Thermoelektrisches Modul (100) gemäß einem der vorangegangenen Ansprüche, **dadurch gekennzeichnet, dass** das Trägerelement (115) und/oder das Abdeckelement (130) im Wärmeleitbereich (125) zumindest eine Mehrzahl von Öffnungen (120, 310) aufweist, die regelmäßig in Reihen und/oder Spalten angeordnet sind.

5. Thermoelektrisches Modul (100) gemäß einem der vorangegangenen Ansprüche, **dadurch gekennzeichnet, dass** das Abdeckelement (130) im das thermoelektrische Element (110) überdeckenden Bereich zumindest eine Öffnung (310) und/oder oder zumindest ein Abdeckleitelement (320) zur Wärmeleitung durch das Abdeckelement (130) aufweist, wobei das Abdeckleitelement (320) eine höhere Wärmeleitfähigkeit als ein Hauptbestandteilmaterial des Abdeckelements (130) umfasst, insbesondere wobei das Abdeckleitelement (320) zumindest teilweise ein Metall umfasst oder vollständig aus Metall besteht.

6. Thermoelektrisches Modul (100) gemäß einem der vorangegangenen Ansprüche, **dadurch gekennzeichnet, dass** das Abdeckelement (130) durch eine Vergussmasse und/oder eine Leiterplatte gebildet ist und/oder an einer dem Trägerelement (115) gegenüberliegenden Seite in Kontakt mit dem thermoelektrischen Element (110) steht.

7. Thermoelektrisches Modul (100) gemäß einem der vorangegangenen Ansprüche, **dadurch gekennzeichnet, dass** ferner zumindest ein Zwischenelement (520) vorgesehen ist, welches seitlich neben dem thermoelektrischen Element (110) zwischen dem Abdeckelement (130) dem Trägerelement (115) angeordnet ist, insbesondere wobei das Zwischenelement (520) zusammen mit dem Abdeckelement (130) und dem Trägerelement (115) ein Gehäuse ausbildet, welches das thermoelektrische Element (110) zumindest teilweise einschließt.

8. Thermoelektrisches Modul (100) gemäß Anspruch 7, **dadurch gekennzeichnet, dass** das Zwischenelement (520) zumindest eine Zwischenelementleiterbahn (510) aufweist, um einen elektrischen Leiter (200) an und/oder im Trägerelement (115) mit einem elektrischen Leiter (560) an und/oder im Abdeckelement (130) zu verbinden.

9. Thermoelektrisches Modul (100) gemäß einem der vorangegangenen Ansprüche 7 oder 8, **dadurch gekennzeichnet, dass** das zwischen dem Zwischenelement (520) und dem thermoelektrischen Element (110) ein Hohlraum (135) ausgebildet ist, insbesondere wobei der Hohlraum (135) mit einem Fluid, insbesondere einem Gas oder Luft gefüllt ist.

10. Thermoelektrisches Modul (100) gemäß einem der vorangegangenen Ansprüche, **gekennzeichnet durch** zumindest ein elektronisches Bauelement und/oder ein Sensorelement (210) zum Erfassen einer physikalischen Größe, insbesondere wobei das Sensorelement (210) mit dem thermoelektrischen Element (110) elektrisch leitfähig verbunden ist, um mit einer vom thermoelektrischen Element (110) bereitgestellten elektrischen Energie betrieben zu werden.

11. Thermoelektrisches Modul (100) gemäß Anspruch 10, **dadurch gekennzeichnet, dass** das zumindest eine elektronische Bauelement und/oder Sensorelement (210) auf einer dem thermoelektrischen Element (110) zugewandten Seite des Abdeckelementes (130) und/oder auf einer dem thermoelektrischen Element (110) zugewandten Seite des Trägerelementes (115) befestigt ist.

12. Thermoelektrisches Modul (100) gemäß einem der vorangegangenen Ansprüche, **dadurch gekennzeichnet, dass** das zumindest ein Messfühler (700) zur Erfassung eines physikalischen Größe auf einer dem thermoelektrischen Element (110) abgewandten Seite des Trägerelementes (115) und/oder des Abdeckelementes (130) angeordnet ist, insbesondere wobei der Messfühler (700) mit dem thermoelektrischen Element (110) elektrisch leitfähig verbunden ist, um mit von dem thermoelektrischen Element (110) bereitgestellter Energie betrieben zu werden, insbesondere wobei der zumindest eine Messfühler (700) von einem Gehäuse (800) zumindest teilweise umschlossen ist.

13. Thermoelektrisches Modul (100) gemäß einem der vorangegangenen Ansprüche, **dadurch gekennzeichnet, dass** zumindest ein Deckel (800) auf einer dem Abdeckelement (130) abgewandten Seite des Trägerelementes (115) und/oder auf einer dem Trägerelement (115) abgewandten Seite des Abdeckelementes (130) angeordnet ist, wobei der Deckel (800) zumindest teilweise ein metallisches Material oder eine metallische Schicht aufweist.

14. Verfahren (1000) zur Herstellung eines thermoelektrischen Moduls (100), wobei das Verfahren (1000) die folgenden Schritte aufweist:
- Bereitstellen (1010) zumindest eines Trägerelement (115), wobei das Trägerelement (115) zumindest einen Wärmeleitbereich (125) zur Wärmeleitung zwischen zwei gegenüberliegenden Seiten des Trägerelementes aufweist, wobei der Wärmeleitbereich (125) eine höhere Wärmeleitfähigkeit als ein weiterer Bereich des Trägerelementes aufweist, eines thermoelektrischen Elements, und zumindest eines Abdeckelements (130); und
- Anordnen (1020) des Trägerelementes (115), des thermoelektrischen Elementes (110) und des Abdeckelementes (130) derart, dass das thermoelektrische Element (110) auf dem Wärmeleitbereich (125) des Trägerelementes befestigt und mit dem Wärmeleitbereich (125) thermisch gekoppelt wird und dass das Abdeckelement (130) auf einer dem Trägerelement (115) gegenüberliegenden Seite des thermoelektrischen Elementes (110) angeordnet wird und das thermoelektrische Element (110) zumindest teilweise überdeckt.

15. Computer-Programmprodukt mit Programmcode zur Durchführung und/oder Ansteuerung der Schritte des Verfahrens (1000) nach Anspruch 13, wenn das Programmprodukt auf einer Vorrichtung ausgeführt wird.
